# FASCICULE DE BREVET EUROPEEN

(11) **EP 2 748 852 B1**
(45) Date de publication et mention de la délivrance du brevet: **05.02.2020**
(21) Numéro de dépôt: 12740947.2
(22) Date de dépôt: 25.07.2012
(51) Int. Cl.: H01L 27/146, H04N 5/355, H04N 5/3745, H04N 5/347

(54) **CAPTEUR D'IMAGE A REGROUPEMENT DE PIXELS**
PIXEL-GRUPPIERENDER BILDSENSOR
PIXEL-GROUPING IMAGE SENSOR

(30) Priorité: 26.08.2011 FR 1157549
(43) Date de publication de la demande: 02.07.2014
(73) Titulaire: Teledyne e2v Semiconductors SAS, 38120 Saint-Egrève (FR)
(72) Inventeur: MAYER, Frédéric, 38500 Voiron (FR); GUILLON, Marie, 38000 Grenoble (FR)
(74) Mandataire: Lucas, Laurent Jacques
(86) Numéro de dépôt international: PCT/EP2012/064618
(87) Numéro de publication internationale: WO 2013/029885

(56) Documents cités:
- EP-A1- 2 037 672
- WO-A2-02/28095
- US-A- 5 134 087
- US-A1- 2003 020 000
- US-A1- 2004 135 063
- US-A1- 2007 131 992
- US-A1- 2009 073 281

## Description

L'invention concerne les capteurs d'image matriciels organisés en lignes et colonnes de pixel, et plus spécialement les capteurs d'image réalisés avec des pixels actifs en technologie MOS, dans lesquels chaque pixel comprend au moins une photodiode et des transistors servant à effectuer une conversion charge-tension dans le pixel.

On a déjà proposé de réaliser des capteurs matriciels dans laquelle la résolution et la sensibilité peuvent être modifiées au choix par l'utilisateur en regroupant plusieurs pixels voisins. Pour une meilleure résolution, les pixels sont lus indépendamment les uns des autres. Pour une meilleure sensibilité au prix d'une plus faible résolution, les pixels sont regroupés et fournissent un signal unique pour chaque groupe de pixels. On peut regrouper les pixels adjacents 2 par 2 ou 4 par 4 ou plus généralement m par n, m et n étant deux entiers dont l'un au moins est supérieur ou égal à 2.

Le regroupement de pixels (ou "binning" en anglais) a été utilisé dans les technologies CCD (dispositifs à transferts de charges) ou il est particulièrement efficace car il permet d'additionner les charges photogénérées par simple transfert de charges. Dans les technologies MOS à pixels actifs, c'est plus compliqué car le signal de sortie des pixels est une tension ; si on numérise la tension et qu'on additionne plusieurs signaux numérisés pour faire un regroupement de pixels, on additionne les bruits également.

On a cependant proposé, même dans les technologies MOS à pixels actifs, des structures de transfert de charges permettant de regrouper à volonté, sous forme analogique, les charges photogénérées dans plusieurs pixels. On fait le regroupement de charges en partageant les nœuds de stockage de charges de pixels adjacents avant de convertir les charges en tension ; l'inconvénient des dispositifs proposés est que cela complique la lecture des pixels individuels lorsqu'on ne veut pas les regrouper ; de plus, ces dispositifs présentent un facteur de conversion charge-tension plus faible lorsque les pixels sont regroupés que lorsqu'ils restent distincts.

Par exemple, on a proposé dans le brevet GB2474014 une architecture permettant un partage conditionnel des charges entre deux pixels au moyen d'un transistor qui relie ou non les nœuds de stockage de charge de deux pixels adjacents. La capacité du nœud de stockage de charges augmente beaucoup lorsqu'on fait ce partage, ce qui réduit le facteur de conversion charge-tension.

Enfin, dans le brevet US6452153, on a proposé un partage de charges dans le cadre d'un pixel qui ne comporte pas de transistor d'isolation entre la photodiode et un nœud de stockage de charges et qui au lieu de cela comporte un transistor dit « d'écrêmage » (skimming en anglais) polarisé en continu. On utilise dans ce brevet une architecture avec un transistor de regroupement qui est disposé de manière à relier les sorties de plusieurs photodiodes au transistor de lecture d'un seul des pixels. Bien que le facteur de conversion charge-tension reste le même lorsque les pixels sont séparés et lorsqu'ils sont regroupés, la solution décrite dans ce brevet a un inconvénient majeur qui est une faible efficacité de transfert car les charges de la photodiode la plus éloignée du pixel de regroupement ont du mal à parvenir jusqu'au circuit de lecture de ce pixel. Les charges non transférées se retrouveront dans l'image suivante, donnant lieu à un phénomène de retard qui détériore l'image. De plus, cette structure est très peu efficace à faible niveau de signal car elle fonctionne par écrêmage de charges au-dessus d'un certain niveau. Or le regroupement de charges est surtout intéressant à bas niveau de lumière.

On connaît par ailleurs les publications de brevet US 2009/0073281 et 2004/0135063 comprenant des moyens de regroupement de charges de plusieurs pixels.

La présente invention vise à proposer un capteur dans lequel un regroupement de pixels est possible, sans changement significatif du facteur de conversion, et avec cependant une bonne efficacité de transfert.

Le capteur selon l'invention permet de recueillir indépendamment ou de manière regroupée les charges photogénérées dans au moins deux pixels adjacents. Il comporte une grille de stockage temporaire entre les photodiodes des deux pixels et des moyens de commande de cette grille. Pendant l'intégration de charges, la grille est portée à un potentiel qui interdit le passage de charges entre les photodiodes des deux pixels. Les charges intégrées dans chaque pixel sont lues individuellement si on ne désire pas un regroupement de pixels. Si on désire un regroupement de pixels à la fin d'une période d'intégration de charges, la grille de stockage temporaire reçoit un signal de commande de stockage temporaire qui la porte à un potentiel haut ; de ce fait, les charges des deux photodiodes se déversent sous cette grille ; puis, à la fin du signal de commande de stockage temporaire, la grille revient à un potentiel bas qui tend à évacuer les charges qu'elle avait stockées. La grille est constituée d'une manière dissymétrique entre son côté amont (côté qui reçoit des charges) et son côté aval (côté qui fournit) des charges) pour assurer une directivité du transfert de charges dans cette dernière phase, afin que les charges stockées sous la grille de stockage temporaire ne repartent que vers une seule des deux photodiodes. Le pixel correspondant à la photodiode qui a ainsi regroupé les charges de deux pixels est alors lu.

Cette dissymétrie de la grille de stockage intermédiaire consiste de préférence à créer sous la grille de stockage temporaire et d'un côté de celle-ci (qu'on appellera côté amont) un couloir d'étranglement pour le passage de charges du côté de la photodiode située en amont ; ce couloir est entouré de zones dopées portées à un potentiel de référence, et il est suffisamment étroit pour que le potentiel dans le couloir, influencé par ces zones dopées de part et d'autre du couloir, reste plus bas que le potentiel sous la grille du côté aval après la fin du signal de stockage temporaire ; ainsi une barrière de potentiel se crée dans le couloir étroit, ce qui force les charges stockées sous la grille de stockage temporaire à se diriger du côté aval.

Par conséquent, l'invention propose un capteur d'image selon la revendication 1, comportant une matrice de lignes et de colonnes de pixels, chaque pixel comportant une photodiode et un nœud de stockage de charges pour recueillir, à la fin d'une période d'intégration de charges, les charges accumulées dans la photodiode, la matrice étant organisée en groupes d'au moins deux pixels avec des moyens pour regrouper dans un pixel les charges engendrées dans les deux pixels, comportant une grille de stockage temporaire de charges, présentant une dissymétrie entre un côté amont et un côté aval, disposée entre la photodiode du premier pixel et la photodiode du deuxième pixel, et des moyens pour appliquer à la grille de stockage temporaire une succession de potentiels qui sont :
- un potentiel bas interdisant le passage de charges entre la première et la deuxième photodiodes pendant la durée d'intégration de charges,
- puis un signal de commande de stockage temporaire à potentiel haut autorisant le déversement des charges accumulées dans les deux photodiodes sous la grille de stockage temporaire,
- puis un potentiel bas permettant le déversement des charges de la grille de stockage intermédiaire vers la deuxième photodiode seulement.

La dissymétrie de la grille de stockage temporaire s'entend comme étant une dissymétrie dans le sens de transfert des charges, le côté amont étant différent du côté aval ; ceci n'exclut pas une symétrie par rapport à un axe parallèle au sens de transfert des charges.

En pratique, les photodiodes sont réalisées dans une couche semiconductrice active d'un premier type de conductivité et comportent une diffusion d'un deuxième type de conductivité recouverte par une couche superficielle du premier type reliée à un potentiel de référence de la couche active ; la grille de stockage temporaire est disposée au-dessus d'une portion de couche active du premier type, cette portion de couche active étant :
- adjacente à la photodiode du premier pixel par l'extrémité d'au moins un couloir étroit s'étendant vers cette photodiode,
- adjacente à la photodiode du deuxième pixel par un côté plus large que le couloir étroit,
- et étant, à l'exception de l'extrémité du couloir étroit, séparée de la photodiode du premier pixel par des régions d'isolation dopées du premier type de conductivité, plus dopées que la couche superficielle des photodiodes, et portées comme elles au potentiel de référence de la couche active.

Le couloir est suffisamment étroit pour établir dans la couche active une barrière de potentiel plus haute que du côté aval. Il peut y avoir plusieurs couloirs étroits du côté amont, pourvu que chacun d'eux soit suffisamment étroit pour établir dans la couche active une telle barrière de potentiel. Des régions d'isolation dopées du premier type de conductivité séparent la photodiode de la portion de couche active partout en dehors de l'extrémité de ces couloirs étroits.

Dans une réalisation possible, la matrice est organisée en groupe de quatre pixels, un premier et un deuxième pixels d'un groupe de quatre sont deux pixels adjacents d'une première ligne de pixels et un troisième et un quatrième pixels sont deux pixels adjacents d'une ligne adjacente à la première, et au moins trois grilles de stockage temporaire dissymétriques (au sens indiqué précédemment) sont prévues pour autoriser un regroupement de charges des photodiodes des quatre pixels dans la photodiode du quatrième pixel.

Le regroupement de charges peut s'effectuer de plusieurs manières possibles, dépendant de la commande des grilles de stockage temporaire.

Dans une solution, une première grille de stockage temporaire est prévue entre le premier et le deuxième pixel, une deuxième grille est prévue entre le deuxième et le troisième pixel, et une troisième grille est prévue entre le troisième et le quatrième pixel, et des moyens sont prévus pour commander les grilles successivement, le signal de commande de stockage de la deuxième grille étant appliqué à celle-ci seulement après la fin du signal de commande de stockage appliqué à la première grille et le signal de commande de stockage de la troisième grille étant appliqué à celle-ci seulement après la fin du signal de commande de stockage appliqué à la deuxième grille. Ainsi, les charges passent de la première photodiode à la deuxième, puis à la troisième, et enfin à la quatrième.

Dans une autre solution, une première grille de stockage temporaire est prévue entre le premier et le quatrième pixel, une deuxième grille est prévue entre le deuxième et le troisième pixel, et une troisième grille est prévue entre le troisième et le quatrième pixel, et des moyens sont prévus pour commander les grilles en deux étapes successives, le signal de commande de stockage de la première grille étant appliqué à celle-ci en même temps que le signal de commande de stockage de la deuxième grille et le signal de commande de stockage de la troisième grille étant appliqué à celle-ci seulement après la fin du signal de commande de stockage appliqué aux première et deuxième grilles. Ainsi, les charges passent en même temps de la première et la deuxième photodiode vers la quatrième et la troisième respectivement ; puis elles passent de la troisième vers la quatrième.

Enfin, la matrice peut également être organisée en groupes de nxm pixels, avec (nxm-1) grilles de stockage temporaires entre la photodiode du pixel et chacun des pixels adjacents. Il faut au moins (m+n-2) signaux de regroupement pour effectuer le regroupement dans le dernier pixel.

Dans tous les cas, le facteur de conversion charge -tension est le même lorsque la matrice fonctionne sans regroupement de pixels et avec regroupements de pixels : c'est le facteur de conversion lié à la capacité du nœud de stockage de charges du pixel.

D'autres caractéristiques et avantages de l'invention apparaîtront à la lecture de la description détaillée qui suit et qui est faite en référence aux dessins annexés dans lesquels :
- la figure 1 représente un schéma électrique classique d'un pixel actif à cinq transistors et une photodiode ;
- la figure 2 représente une vue de dessus schématique du pixel, montrant les différents éléments de ce schéma électrique ;
- la figure 3 représente en vue de dessus la configuration d'un groupement de quatre pixels selon l'invention ;
- la figure 4 représente une coupe verticale, selon la ligne A-A de la figure 3, de la grille de stockage temporaire séparant deux photodiodes de pixels adjacents ;
- la figure 5 représente une autre coupe de la grille de stockage temporaire, selon la ligne B-B de la figure 3 ;
- la figure 6 représente un diagramme des potentiels successifs dans le semiconducteur au cours d'une opération de regroupement, avec sur la gauche de la figure les potentiels le long de la ligne A-A et sur la droite les potentiels le long de la ligne B-B ;
- la figure 7 représente un diagramme temporel des signaux appliqués aux pixels pour la lecture des charges photogénérées en mode de regroupement de pixels ;
- la figure 8 représente une variante de réalisation des grilles de stockage temporaire d'un groupement de quatre pixels.

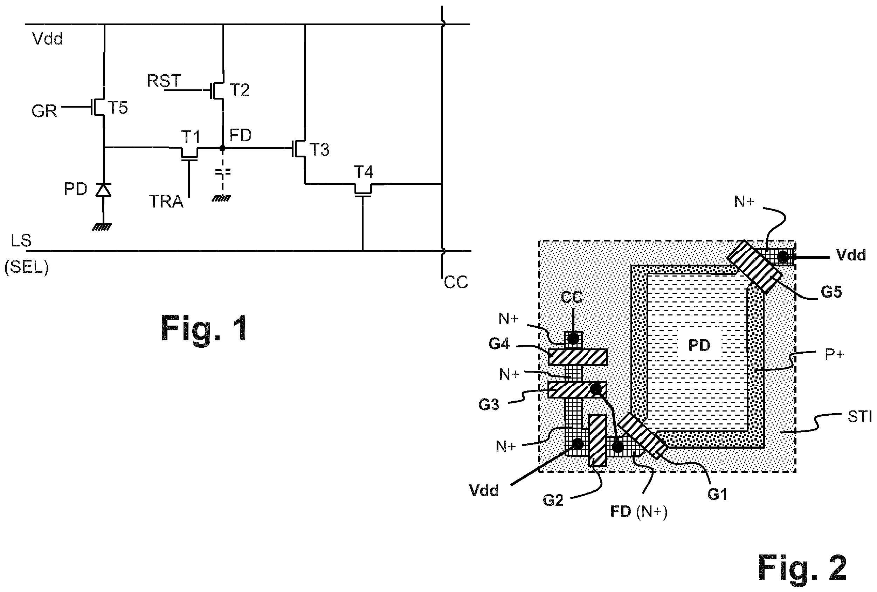

Sur le schéma de la figure 1, on voit un pixel faisant partie d'un capteur matriciel de multiples lignes et colonnes de pixels ; chaque pixel comporte :
- une photodiode PD,
- un transistor de transfert T1 permettant, lorsqu'il est bloqué, une isolation complète entre la photodiode et un nœud de stockage de charges FD puis, lorsqu'il est rendu conducteur, le transfert des charges générées dans la photodiode vers le nœud de stockage de charges FD ; le transistor T1 est commandé par un signal de transfert TRA qui peut être commun à toute la matrice ou au moins commun à une ligne de pixels ;
- un transistor T2 permettant la réinitialisation du potentiel du nœud de stockage avant le transfert contrôlé par le transistor T1 ; lorsqu'il est rendu conducteur, il porte le nœud de stockage à une tension de référence qui peut être par exemple le potentiel d'alimentation générale Vdd ; la commande de réinitialisation est faite ligne par ligne ;
- un transistor de lecture T3 monté en suiveur de tension, permettant de reporter sur la source de ce transistor le potentiel présent sur sa grille ; sa grille est reliée au nœud de stockage FD ;
- un transistor de sélection de ligne T4 reliant la source du transistor de lecture à un conducteur de colonne CC commun à tous les pixels d'une même colonne ; le transistor T4 est commandé par un conducteur de ligne LS commun à tous les pixels d'une même ligne ; ce conducteur de ligne est commandé par un signal de sélection SEL issu d'un décodeur de ligne qui adresse successivement les différentes lignes de pixels.

Un transistor T5 facultatif peut être prévu pour réinitialiser le potentiel de la photodiode au début d'une période d'intégration de charge ; ce transistor est commandé à cet effet par un signal GR, global pour toute la matrice.

Classiquement, on rend conducteur les transistors T4 d'une seule ligne de pixels, et on fait une lecture de signal par double échantillonnage : on recueille individuellement sur les conducteurs de colonne CC des potentiels représentant l'accumulation de charges dans chacun des pixels de la ligne, puis on réinitialise le potentiel du nœud de stockage de la ligne considérée et on recueille sur les conducteurs de colonne un potentiel de réinitialisation. La lecture est faite par différence des deux potentiels recueillis pour chaque pixel.

La figure 2 représente en vue de dessus une configuration physique possible du schéma électrique de la figure 1. Les éléments du schéma sont formés à partir d'une couche active semiconductrice qui est par exemple de type P-, peu dopée.

La photodiode PD est une diffusion de type N dans cette couche P-, et elle est de préférence surmontée d'une fine couche superficielle de type P portée à un potentiel de référence bas qui est le potentiel de la couche semiconductrice de type P- ; il s'agit donc d'une photodiode de type "pinned", de l'anglais "épinglé", dont le potentiel de surface est fixe pendant l'intégration de charges.

La photodiode peut être délimitée latéralement, localement ou même sur presque toute sa périphérie, par une couche de type P+ plus profonde et plus dopée que la couche superficielle de la photodiode. Cette couche P+ d'isolation est également portée au potentiel de la couche semiconductrice et elle sert à amener à la diffusion superficielle de la photodiode le potentiel de référence de la couche semiconductrice P-. La couche P+ est en tous cas interrompue sur une portion de la périphérie pour autoriser le passage de charges (sous contrôle d'une grille) dans la couche active depuis la photodiode vers le nœud de stockage de charges FD ; ce noeud est une diffusion de type N+ dans la couche semiconductrice. L'interruption de la couche P+, entre la photodiode et le nœud de stockage FD, est recouverte par une grille isolée G1 qui est la grille du transistor T1 de la figure 1. L'isolation entre la photodiode PD et le nœud de stockage FD est assurée lorsque la grille G1 est à un potentiel bas. Le transfert de charges de la photodiode vers le nœud de stockage est assuré lorsque la grille G1 est à un potentiel haut.

Une grille isolée G2 (la grille du transistor de réinitialisation T2 de la figure 1) sépare le nœud de stockage FD d'une autre diffusion de type N+ portée au potentiel de référence de réinitialisation du nœud de stockage FD (ici le potentiel d'alimentation Vdd). Cette diffusion de type N+ sert de drain au transistor T2 et sert également de drain au transistor de lecture T3 ; le drain du transistor T3 est séparé de sa source (une autre diffusion N+) par sa grille G3 ; la grille G3 est électriquement reliée par une connexion au nœud de stockage FD. La diffusion N+ qui sert de source au transistor T3 sert également de drain au transistor de sélection T4 ; la source de ce transistor T4 est reliée au conducteur de colonne CC ; la grille G4 du transistor T4 sépare sa source de son drain. Enfin, si un transistor T5 est prévu dans le pixel pour la réinitialisation du potentiel de la photodiode, une grille supplémentaire G5 sépare la photodiode d'une diffusion de drain de type N+ portée au potentiel Vdd ; cette grille recouvre une autre interruption dans la région P+ entourant la photodiode.

Les zones de type N+ et P+ sont elles-mêmes délimitées par des régions isolantes STI dans lesquelles les charges électriques ne peuvent pas circuler ou se stocker. Ces régions isolantes sont en général formées par des tranchées remplies d'oxyde de silicium isolant, creusées dans la couche active semiconductrice de type P-. La circulation des charges ne s'effectue qu'entre la photodiode et des zones N+ ou entre deux zones N+, en fonction du niveau de potentiel appliqué aux grilles qui autorisent ou interdisent cette circulation.

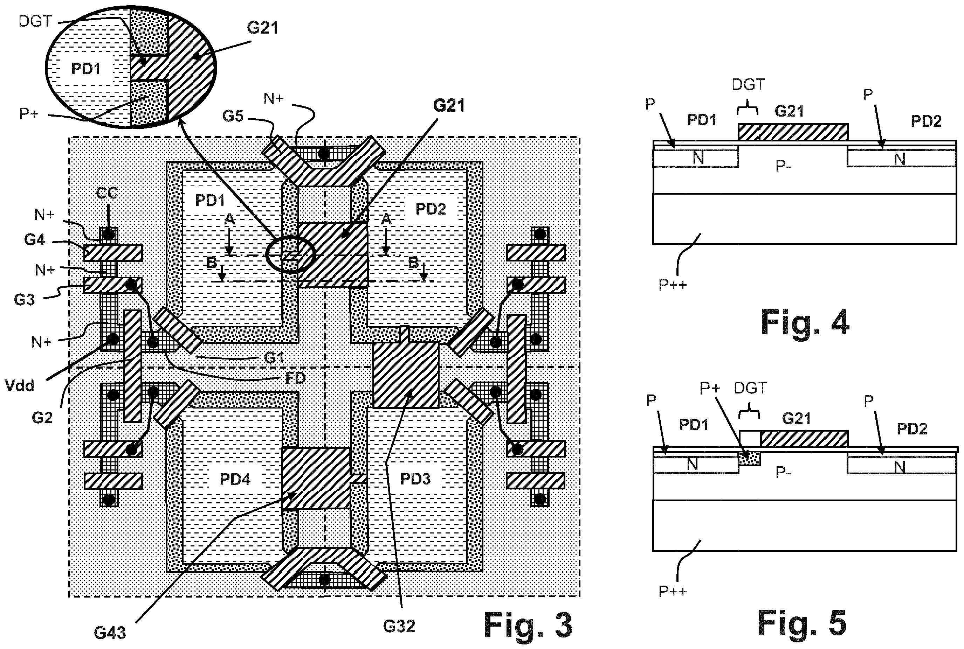

La figure 3 représente un arrangement de quatre pixels selon l'invention permettant soit une lecture individuelle de chaque pixel soit une lecture regroupée des quatre pixels. Des grilles de stockage temporaire sont prévues entre deux photodiodes appartenant à des pixels adjacents et ces grilles ont la particularité d'être dissymétriques pour permettre un transfert directionnel des charges stockées sous ses grilles vers l'une des photodiodes mais pas vers l'autre.

Comme on le voit sur la figure 3, les géométries des quatre pixels sont de préférence inversées lorsqu'on passe d'une colonne à la suivante ou d'une ligne à la suivante, pour faciliter les connexions entre éléments semblables des différents pixels. Les diffusions juxtaposées de pixels adjacents qui doivent être reliées à un même potentiel peuvent être réunies en une seule diffusion s'étendant d'un pixel au pixel adjacent. De même les grilles de pixels adjacents qui doivent être commandées par le même signal peuvent être réunies en une seule grille s'étendant d'un pixel au pixel adjacent. C'est le cas sur la figure 3 pour les diffusions de drain des transistors T5 de deux pixels adjacents en ligne. C'est le cas aussi des grilles G5 de deux pixels adjacents en ligne, et également des grilles G2 de deux pixels adjacents en colonne ; ce pourrait être le cas aussi des grilles G1 de pixels adjacents en colonne, sauf lorsqu'on veut faire un transfert de charges ligne par ligne vers les nœuds de stockage (mode d'intégration de charges dit "rolling shutter").

Selon l'invention, on prévoit des grilles de stockage temporaire de charges entre au moins deux photodiodes adjacentes. Une grille de stockage temporaire située entre deux photodiodes adjacentes peut recueillir la somme des charges générées par les deux photodiodes pendant un temps d'intégration. Un signal de commande de stockage temporaire est émis à cet effet à la fin du temps d'intégration et les charges des deux photodiodes viennent sous la grille pendant ce signal de commande. Les grilles sont de plus constituées de manière dissymétrique entre leur côté amont et leur côté aval, afin de déverser dans une seule des deux photodiodes les charges stockées sous la grille lorsque le signal de commande de stockage se termine.

Dans l'exemple représenté, qui permet un regroupement de quatre pixels, on a prévu :
- une grille G21 permettant de regrouper les charges des photodiodes PD1 et PD2 d'une ligne et de les déverser dans la photodiode PD2 ;
- une grille G32 permettant de regrouper les charges des photodiodes PD2 et PD3 d'une colonne et de les déverser dans la photodiode PD3 ;
- et une grille G43 permettant de regrouper les charges des photodiodes PD3 et PD4 d'une ligne et de les déverser dans la photodiode PD4.

Les signaux de commande de stockage temporaire des trois grilles sont émis successivement à la fin du temps d'intégration. Les charges de la photodiode PD1 passent dans la photodiode PD2 ; les charges accumulées dans la photodiode PD2 passent ensuite dans la photodiode PD3 ; et enfin les charges accumulées dans la photodiode PD3 passent dans la photodiode PD4.

Ainsi, après les trois signaux de stockage intermédiaire successifs, les charges engendrées dans les quatre pixels pendant un temps d'intégration sont regroupées dans la photodiode PD4. Elles peuvent alors être lues sur le conducteur de colonne correspondant à la photodiode PD4.

Les grilles de stockage temporaire sont situées au-dessus de la couche active semiconductrice de type P- et isolées de celle-ci par une fine couche isolante. La zone P+ qui entoure chacune des photodiodes est interrompue à l'endroit de la grille de stockage temporaire (comme elle est interrompue à l'endroit des grilles G1 et G5) et la photodiode est donc adjacente à cet endroit à une portion de couche active semiconductrice de type P- recouverte par la grille de stockage temporaire.

Dans ce qui suit on considérera que la géométrie de la portion de couche active de type P- recouverte par la grille de stockage temporaire est la même que la géométrie de la grille de stockage temporaire elle-même. Il est possible que la grille temporaire déborde (par exemple au-dessus des zones d'isolation STI) au-delà de la portion de couche active dans laquelle les charges peuvent venir se stocker, mais ce qui importe est la forme de la portion de couche active qui permet de stocker des charges, c'est-à-dire la portion de couche active qui est séparée de la grille par une fine couche d'isolation. C'est pourquoi on considérera dans ce qui suit qu'il y a identité entre la forme de la grille et la forme de la portion de couche active qui peut stocker des charges sous la grille, les débordements éventuels de la grille sur les zones isolantes STI n'étant pas considérées comme faisant partie de la grille de stockage temporaire. Les grilles de stockage temporaire sont situées entre deux photodiodes, et la portion de couche active surmontée par la grille est adjacente aux deux photodiodes ; par extension de vocabulaire, on dira pour simplifier que la grille de stockage temporaire est adjacente à une photodiode même si c'est en réalité la portion de couche active P- sous la grille qui est adjacente à la photodiode.

La dissymétrie des grilles est obtenue de la manière suivante : on appelle photodiode aval (la photodiode PD2 pour la grille G21) celle dans laquelle se déversent les charges à la fin d'un signal de commande de stockage temporaire ; la photodiode amont (la photodiode PD1 pour la grille G21) est celle qui ne peut pas recevoir des charges à la fin de ce signal ; la portion de couche active surmontée par la grille G21 est adjacente à la photodiode aval PD2 sur une largeur plus importante que là où elle est adjacente à la photodiode amont PD1 ; les charges peuvent donc passer de la photodiode PD2 à la portion de couche active sous la grille G21 par un large passage mais elles ne peuvent passer de la photodiode PD1 vers la grille G21 qu'à travers un couloir étroit enfermé entre des régions d'isolation de type P+ portées au potentiel de référence de la couche active. La largeur de ce couloir est suffisamment faible pour que le potentiel dans ce couloir soit influencé par la présence de la zone P+ qui l'entoure ; au contraire là où la grille est adjacente à la photodiode aval, la largeur du passage est suffisamment importante pour que le potentiel de la portion de couche active ne soit pas influencé partout par la présence de la zone P+. Il peut y avoir plusieurs couloirs étroits pourvu que chacun des couloirs soit suffisamment étroit pour subir l'influence du potentiel des régions P+ qui l'entourent.

Les grilles de stockage temporaire G21, G32 et G43 comportent donc chacune, comme on voit sur la figure 3, un côté large adjacent à la photodiode située en aval et, du côté amont, au moins un doigt étroit DGT ayant une extrémité adjacente à la photodiode située en amont, le doigt étant latéralement enserré entre des régions de type P+ portées au potentiel de référence de la couche active.

Cette dissymétrie de forme de la grille et de largeur du passage entre la grille et les photodiodes crée, du côté du passage étroit, une barrière de potentiel lors de la fin du signal de commande de stockage temporaire, empêchant le retour des charges vers la photodiode amont, mais ne crée pas de barrière du côté aval, ca qui autorise le retour des charges vers la photodiode aval. On détaillera plus loin l'existence de cette barrière de potentiel.

La figure 4 représente la coupe verticale de la grille de stockage temporaire G21 selon la ligne A-A de la figure 3. La grille isolée repose sur la portion de couche active semiconductrice peu dopée P- ; les photodiodes PD1 et PD2 sont immédiatement à gauche et à droite respectivement de la grille. La coupe est faite à travers le doigt étroit qui relie la portion de couche active à la photodiode amont PD1. La diffusion N de la photodiode amont PD1 touche la portion de couche active de type P- sous le doigt étroit de grille à l'extrémité gauche de celle-ci et uniquement sous ce doigt étroit.

La figure 5 représente la coupe verticale de la grille de stockage G21 selon la ligne B-B de la figure 3, c'est-à-dire en dehors du doigt étroit ; la diffusion N de la photodiode amont PD1 ne touche pas la portion de couche active de type P- située sous la grille car elle en est séparée par la région P+ qui encadre le doigt étroit. Du côté de la photodiode aval, la grille s'avance jusqu'à la photodiode et est adjacente à celle-ci sur toute la largeur de la grille.

Les charges ne peuvent circuler de la photodiode amont PD1 vers la grille de stockage temporaire qu'à travers le couloir étroit, les régions P+ présentes partout ailleurs créant une barrière de potentiel empêchant tout passage de charges entre la photodiode et la région surplombée par la grille. Les charges ne peuvent pas passer de la grille vers la photodiode amont, comme on va le voir.

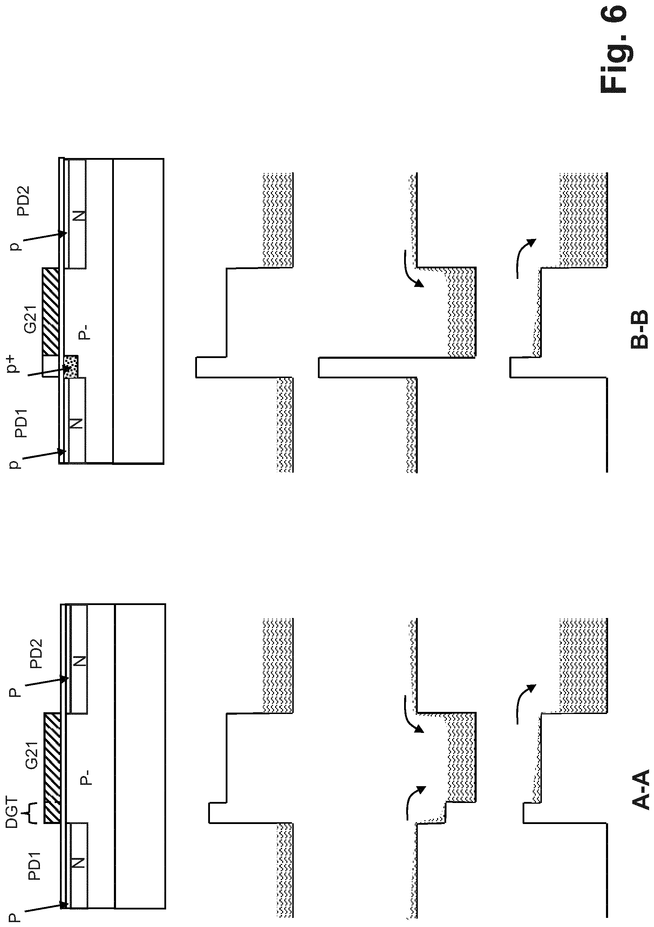

La figure 6 représente un diagramme des potentiels dans le semiconducteur dans la couche semiconductrice active d'abord pendant le temps d'intégration des charges, puis lors de l'application d'un signal de stockage temporaire à la fin du temps d'intégration, et enfin à la fin du signal de stockage temporaire. Sur la partie gauche de la figure 6, le diagramme de potentiels est pris selon la ligne A-A correspondant à la figure 4, donc à travers le couloir étroit ; sur la partie droite, le diagramme est pris selon la ligne B-B correspondant à la figure 5. Les potentiels vont en croissant vers le bas conformément à la représentation classique des puits et barrières de potentiel pour les électrons.

Sur la première ligne de la figure 6 : pendant la durée d'intégration, avant le signal de stockage temporaire, la grille G21 est maintenue à un potentiel bas qui crée sous toute la grille une barrière de potentiel empêchant le passage de charges entre les photodiodes PD1 et PD2. Les charges générées par la lumière dans les pixels s'accumulent dans les photodiodes PD1 et PD2. La barrière de potentiel est légèrement plus haute sous le doigt étroit DGT que sous le reste de la grille, et encore plus haute dans les régions P+, mais à ce stade cela n'a pas d'importance.

Sur la deuxième ligne de la figure 6 : le signal de stockage temporaire, émis seulement si on veut faire un regroupement de charges, est un créneau de potentiel haut qui crée un puits de potentiel au-dessous de la grille ; ce puits est plus profond que le niveau de potentiel sous la photodiode supposée vide de charges. Toutes les charges de la photodiode PD1 se déversent sous la grille G21 en passant sous le doigt étroit (partie gauche de la figure 6) mais pas ailleurs (partie droite de la figure 6 avec une haute barrière de potentiel dans les régions P+). Le potentiel dans la couche active dans le couloir étroit est plus bas que le potentiel sous le reste de la grille de stockage à cause de l'influence du potentiel de la couche P+ qui encadre ce couloir étroit, mais la marche d'escalier qui en résulte n'empêche pas le passage des charges de la photodiode PD1 vers la grille G21. De l'autre côté, les charges de la photodiode aval PD2 se déversent aussi dans le puits de potentiel créé sous la grille G21, sans barrière de potentiel.

Sur la troisième ligne de la figure 6 : la fin du signal de stockage ramène le potentiel de la grille à une valeur basse ; le potentiel sous le doigt étroit DGT (partie gauche de la figure 6) descend plus bas (barrière plus haute) que le potentiel sous la grille G21 à cause de l'influence des régions P+ qui encadrent le doigt étroit. La barrière de potentiel qui se crée ainsi sous le doigt étroit a le même effet (même si elle est moins haute) que la barrière formée par les régions P+ (partie droite de la figure 6) ; elle oblige les charges à se déverser du côté aval où il n'y a pas une telle barrière. Toutes les charges passent dans la photodiode PD2.

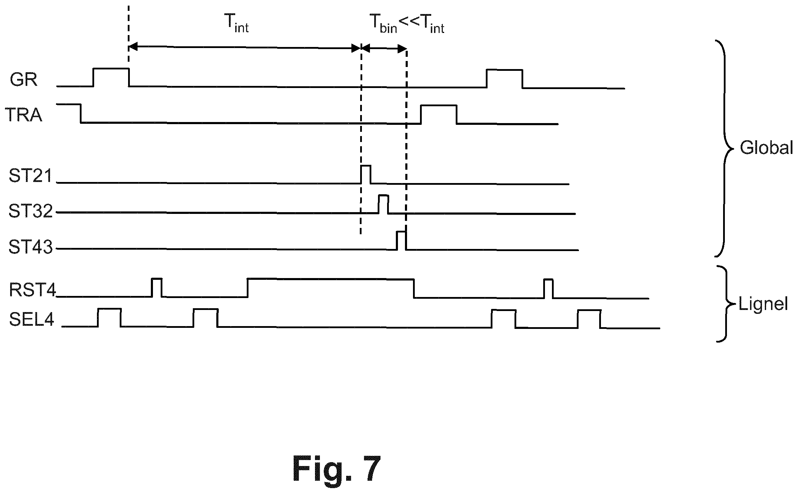

La figure 7 représente un diagramme temporel des signaux de commande des pixels de la matrice dans le cas où on veut faire un regroupement de charges des quatre pixels de la figure 3. Si on ne veut pas faire de regroupement, les signaux de commande sont ceux d'une matrice de pixels classique, les grilles de stockage provisoire étant simplement maintenues à un potentiel bas empêchant tout transfert de charges entre photodiodes ; les pixels sont lus indépendamment les uns des autres, chaque pixel adressé par un conducteur de ligne fournit sur son conducteur de colonne respectif un niveau de potentiel correspondant à son éclairement.

En cas de regroupement on procède de la manière suivante : tout d'abord l'intégration de charges reste classique ; par exemple un signal de réinitialisation globale GR des photodiodes de toute la matrice est appliqué aux grilles G5 de tous les pixels. La fin de ce signal définit le début d'un temps d'intégration. Les grilles de stockage temporaire sont simplement maintenues à un niveau de potentiel bas pendant toute la durée d'intégration Tint.

Juste avant la fin du temps d'intégration, on émet successivement trois impulsions de stockage temporaire ST21, ST32 et ST43, appliquées respectivement aux grilles G21, G32 puis G43. La deuxième impulsion ne commence qu'après que la première soit terminée, et la troisième ne commence qu'après que la deuxième soit terminée. Chaque impulsion fait passer la grille correspondante d'un potentiel bas à un potentiel haut avant de la faire revenir au potentiel bas conformément au diagramme de la fig. 6.

La première impulsion regroupe dans la photodiode PD2 les charges des photodiodes PD1 et PD2 ; la deuxième regroupe dans la photodiode PD3 les charges des photodiodes PD1, PD2 et PD3 ; la troisième regroupe dans la photodiode PD4 la somme des charges des photodiodes PD1, PD2, PD3 et PD4.

Ces impulsions sont communes à tous les groupes de quatre pixels de la matrice.

Le temps de regroupement T_{bin} constitué par ces trois impulsions est très inférieur au temps d'intégration Tᵢₙₜ.

Après la fin de la troisième impulsion ST43, on commande la mise en conduction de tous les transistors de transfert T1 des pixels de la matrice, ce qui met dans le nœud de stockage de charges respectif d'un pixel les charges présentes dans la photodiode de ce pixel. Comme c'est la photodiode PD4 qui contient à ce moment toutes les charges, c'est le nœud de stockage du quatrième pixel qui va recueillir ces charges.

La lecture des pixels regroupés se fait par adressage des quatrièmes pixels de chaque groupe de quatre. Elle consiste à sélectionner la ligne correspondant à ce quatrième pixel et à observer le potentiel sur le conducteur de colonne correspondant à ce quatrième pixel.

La lecture se fait de préférence par double échantillonnage, successivement ligne par ligne (une ligne sur deux de la matrice puisque seul le quatrième pixel est concerné) : on stocke le niveau de potentiel présent sur le conducteur de colonne et qui correspond aux charges regroupées dans la photodiode du quatrième pixel de la ligne adressée et déversées dans le nœud de stockage de ce pixel ; puis on active le transistor de réinitialisation du nœud de stockage de la ligne de pixels concernée et on stocke le niveau de potentiel présent sur le conducteur de colonne. On mesure la différence des deux niveaux de potentiel et on la convertit en numérique.

On pourrait aussi fonctionner en mode d'intégration dit "rolling shutter" où le transistor de transfert est commandé ligne par ligne avec successivement pour chaque ligne : une réinitialisation des nœuds de stockage de la ligne, une lecture des niveaux réinitialisés, un regroupement des charges dans une seule photodiode par les signaux appliqués aux grilles de stockage temporaire, un transfert de charges vers le nœud de stockage, et une lecture des charges transférées.

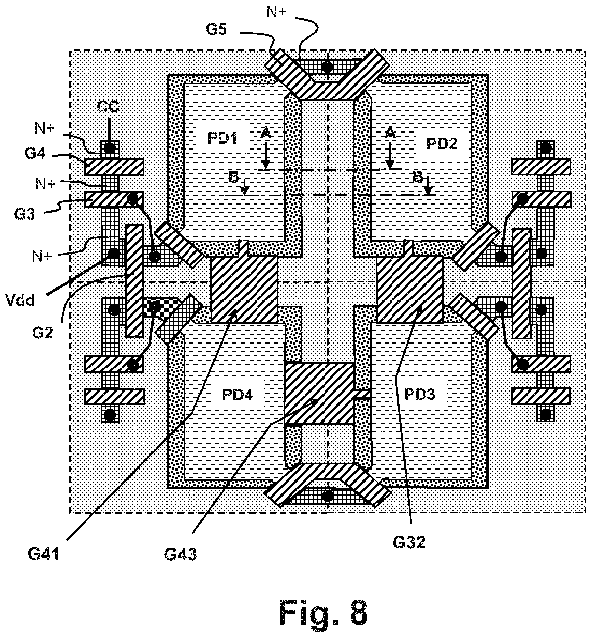

Dans une variante de réalisation représentée à la figure 8, il n'y a pas de grille de stockage temporaire G21 entre les photodiodes PD1 et PD2, mais il y a une grille de stockage G41 entre les photodiodes PD1 et PD4, la photodiode PD1 étant la photodiode amont. Il n'y a que deux signaux de stockage temporaire successifs ; le premier signal commande à la fois les grilles G41 et G32 pour regrouper les charges des photodiodes PD1 et PD4 dans la photodiode PD4, et pour regrouper les charges des photodiodes PD2 et PD3 dans la photodiode PD3 ; le deuxième signal commande la grille G43 comme à la figure 3 pour regrouper les charges des photodiodes PD3 et PD4 dans a photodiode PD4.

Dans la configuration de grilles de la figure 8, on pourrait aussi commander d'abord la grille G32, puis commander simultanément les grilles G41 et G43.

On a décrit l'invention pour un regroupement de quatre pixels ; elle est cependant applicable même si on veut ne regrouper les pixels que deux à deux. Il suffit alors d'une grille de stockage temporaire entre les photodiodes des deux pixels. L'invention est applicable aussi si on veut regrouper plus de deux pixels en ligne et plus de deux pixels en colonne. Si on veut regrouper nxm pixels, avec (n+m)>=2, il faudra (nxm-1) grilles de stockage temporaires entre la photodiode du pixel et chacun des pixels adjacents. Il faut en principe (m+n-2) signaux de regroupement successifs pour effectuer le regroupement dans le dernier pixel de chacun des groupes de la matrice.

De manière générale, on peut prévoir qu'il y a des grilles de stockage temporaire entre tous les pixels adjacents, même si certaines de ces grilles ne sont pas utilisées pour un regroupement. Cela permet de choisir un regroupement avec un nombre de pixels variable en appliquant des signaux de commande aux grilles en fonction du regroupement souhaité. Cela permet aussi, par la présence de grilles de stockage même inutilisées, d'uniformiser le comportement de tous les pixels.

## Revendications

1. Capteur d'image comportant une matrice de lignes et de colonnes de pixels, chaque pixel comportant une photodiode et un nœud de stockage de charges pour recueillir, à la fin d'une période d'intégration de charges, les charges accumulées dans la photodiode, les photodiodes étant réalisées dans une couche semiconductrice active d'un premier type de conductivité et comportant une diffusion d'un deuxième type de conductivité recouverte par une couche superficielle du premier type reliée à un potentiel de référence de la couche active et la matrice étant organisée en groupes d'au moins deux pixels adjacents, avec des moyens pour regrouper dans un pixel les charges engendrées dans les deux pixels, comportant au moins une grille (G21) de stockage temporaire de charges disposée entre la photodiode (PD1) du premier pixel et la photodiode (PD2) du deuxième pixel, la grille de stockage temporaire étant disposée au-dessus d'une portion de couche active du premier type et constituée de manière dissymétrique entre un côté amont et un côté aval, étant :
- sur le côté amont, adjacente à la photodiode (PD1) du premier pixel par l'extrémité d'au moins un doigt étroit (DGT) s'étendant vers cette photodiode (PD1),
- sur le côté aval, adjacente à la photodiode (PD2) du deuxième pixel par un côté plus large que le doigt étroit,
- et, à l'exception de l'extrémité du doigt étroit, séparée de la photodiode du premier pixel par une région d'isolation dopée du premier type de conductivité, plus dopée que les régions superficielles des photodiodes, et portées comme elles au potentiel de la couche active
et des moyens étant prévus pour appliquer à la grille de stockage temporaire une succession de potentiels qui sont :
- un potentiel bas interdisant le passage de charges entre la photodiode (PD1) du premier pixel et la photodiode (PD2) du deuxième pixel pendant la durée d'intégration de charges,
- puis un signal de commande de stockage temporaire à potentiel haut autorisant le déversement des charges accumulées dans la photodiode (PD1) du premier pixel et la photodiode (PD2) du deuxième pixel sous la grille de stockage temporaire,
- puis un potentiel bas permettant le déversement des charges de la grille de stockage intermédiaire vers la photodiode (PD2) du deuxième pixel seulement.

2. Capteur d'image selon la revendication 1, **caractérisé en ce que** la portion de couche active située sous la grille comporte plusieurs doigts étroits s'étendant vers la photodiode du premier pixel et ayant une extrémité adjacente à cette photodiode.

3. Capteur d'image selon la revendication 1 ou 2, **caractérisé en ce que** la matrice est organisée en groupes de quatre pixels deux à deux adjacents sur une ligne ou une colonne, un premier (PD1) et un deuxième (PD2) pixels d'un groupe de quatre sont deux pixels adjacents d'une première ligne de pixels et un troisième (PD3) et un quatrième (PD4) pixels sont deux pixels adjacents d'une autre ligne adjacente à la première, et au moins trois grilles de stockage temporaire dissymétriques (G21, G32, G43) étant prévues pour autoriser un regroupement de charges des photodiodes des quatre pixels dans la photodiode du quatrième pixel, chaque grille étant constituée de façon dissymétrique entre deux pixels adjacents du groupe de quatre pour assurer une directivité du transfert de charges depuis la photodiode d'un pixel vers la photodiode de l'autre pixel.

4. Capteur d'image selon la revendication 3, **caractérisé en ce qu'**une première grille de stockage temporaire (G21) est prévue entre le premier et le deuxième pixel, une deuxième grille (G32) est prévue entre le deuxième et le troisième pixel, et une troisième grille (G43) est prévue entre le troisième et le quatrième pixel, et des moyens sont prévus pour commander les grilles successivement, le signal de commande de stockage de la deuxième grille (ST32) étant appliqué à celle-ci seulement après la fin du signal de commande de stockage (ST21) appliqué à la première grille et le signal de commande de stockage de la troisième grille (ST43) étant appliqué à celle-ci seulement après la fin du signal de commande de stockage (ST32) appliqué à la deuxième grille.

5. Capteur d'image selon la revendication 3, **caractérisé en ce qu'**une première grille de stockage temporaire (G41) est prévue entre le premier et le quatrième pixel, une deuxième grille (G32) est prévue entre le deuxième et le troisième pixel, et une troisième grille (G43) est prévue entre le troisième et le quatrième pixel, et des moyens sont prévus pour commander les grilles en deux étapes successives, le signal de commande de stockage de la première grille étant appliqué à celle-ci en même temps que le signal de commande de stockage de la deuxième grille et le signal de commande de stockage de la troisième grille étant appliqué à celle-ci seulement après la fin du signal de commande de stockage appliqué aux première et deuxième grilles.

6. Capteur d'image selon la revendications 1 ou 2, **caractérisé en ce que** la matrice est organisée en groupes de nxm pixels, avec (n+m)>=2 et comporte (nxm-1) grilles de stockage temporaire entre des photodiodes de pixels adjacents pour assurer le regroupement de charges d'un groupe de nxm pixels.

7. Capteur d'image selon la revendication 6, **caractérisé en ce qu'**il est prévu des moyens pour établir n+m-2 signaux de commande pour commander les grilles de stockage temporaire de la matrice.

## Patentansprüche

1. Bildsensor, der eine Matrix von Pixelreihen und -spalten umfasst, wobei jedes Pixel eine Fotodiode und einen Ladungsspeicherknoten umfasst, um am Ende einer Ladungsintegrationsperiode die in der Fotodiode akkumulierten Ladungen zu sammeln, wobei die Fotodioden in einer aktiven Halbleiterschicht eines ersten Leitfähigkeitstyps realisiert sind und eine Diffusion eines zweiten Leitfähigkeitstyps umfassen, bedeckt mit einer Oberflächenschicht des ersten Typs, die mit einem Referenzpotential der aktiven Schicht verbunden ist, wobei die Matrix in Gruppen von wenigstens zwei benachbarten Pixeln organisiert ist, mit Mitteln zum Gruppieren der in den beiden Pixeln erzeugten Ladungen in einem Pixel, umfassend wenigstens ein Gitter (G21) zum temporären Speichern von Ladungen, das zwischen der Fotodiode (PD1) des ersten Pixels und der Fotodiode (PD2) des zweiten Pixels angeordnet ist, wobei das Gitter zum temporären Speichern über einem aktiven Schichtabschnitt des ersten Typs angeordnet ist und auf unsymmetrische Weise zwischen einer stromaufwärtigen Seite und einer stromabwärtigen Seite gebildet wird, nämlich:
- auf der stromaufwärtigen Seite neben der Fotodiode (PD1) des ersten Pixels durch das Ende von wenigstens einem schmalen Finger (DGT), der sich zu dieser Fotodiode (PD1) erstreckt,
- auf der stromabwärtigen Seite neben der Fotodiode (PD2) des zweiten Pixels durch eine Seite, die breiter ist als der schmale Finger,
- und, mit Ausnahme des Endes des schmalen Fingers, getrennt von der Fotodiode des ersten Pixels durch eine mit dem ersten Leitfähigkeitstyp dotierte Isolationsschicht, die stärker dotiert ist als die Oberflächenregionen der Fotodioden, und wie diese auf das Potential der aktiven Schicht gebracht,
und wobei Mittel zum Anlegen einer Folge von Potentialen an das temporäre Speichergitter vorgesehen sind, nämlich:
- ein tiefes Potential, das die Passage von Ladungen zwischen der Fotodiode (PD1) des ersten Pixels und der Fotodiode (PD2) des zweiten Pixels während der Ladungsintegrationsdauer nicht zulässt,
- dann ein Steuersignal zum temporären Speichern auf hohem Potential, das das Ausschütten der akkumulierten Ladungen in der Fotodiode (PD1) des ersten Pixels und der Fotodiode (PD2) des zweiten Pixels unter dem temporären Speichergitter zulässt,
- dann ein niedriges Potential, das das Ausschütten von Ladungen des Zwischenspeichergitters nur zur Fotodiode (PD2) des zweiten Pixels zulässt.

2. Bildsensor nach Anspruch 1, **dadurch gekennzeichnet, dass** der unter dem Gitter befindliche aktive Schichtabschnitt mehrere schmale Finger umfasst, die sich zur Fotodiode des ersten Pixels erstrecken und ein Ende neben dieser Fotodiode haben.

3. Bildsensor nach Anspruch 1 oder 2, **dadurch gekennzeichnet, dass** die Matrix in Gruppen von vier Pixeln paarweise neben einer Reihe oder einer Spalte organisiert sind, ein erstes (PD1) und ein zweites (PD2) Pixel einer Vierergruppe zwei benachbarte Pixel einer ersten Reihe von Pixeln sind und ein drittes (PD3) und ein viertes (PD4) Pixel zwei benachbarte Pixel einer anderen der ersten benachbarten Reihe sind, und wenigstens drei unsymmetrische temporäre Speichergitter (G21, G32, G43) vorgesehen sind, um eine Gruppierung von Ladungen von Fotodioden von vier Pixeln in der Fotodiode des vierten Pixels vorgesehen sind, wobei jedes Gitter auf unsymmetrische Weise zwischen zwei benachbarten Pixeln der Vierergruppe gebildet wird, um eine Direktivität der Ladungsübertragung von der Fotodiode eines Pixels zur Fotodiode des anderen Pixels zu gewährleisten.

4. Bildsensor nach Anspruch 3, **dadurch gekennzeichnet, dass** ein erstes temporäres Speichergitter (G21) zwischen dem ersten und dem zweiten Pixel vorgesehen ist, ein zweites Gitter (G32) zwischen dem zweiten und dem dritten Pixel vorgesehen ist und ein drittes Gitter (G43) zwischen dem dritten und dem vierten Pixel vorgesehen ist und Mittel zum sukzessiven Steuern der Gitter vorgesehen sind, wobei das Speichersteuersignal des zweiten Gitters (ST32) erst nach dem Ende des an das erste Gitter angelegten Speichersteuersignals (ST21) an dieses angelegt wird und das Speichersteuersignal des dritten Gitters (ST43) erst nach dem Ende des an das zweite Gitter angelegten Speichersteuersignals (ST32) an dieses angelegt wird.

5. Bildsensor nach Anspruch 3, **dadurch gekennzeichnet, dass** ein erstes temporäres Speichergitter (G41) zwischen dem ersten und dem vierten Pixel vorgesehen ist, ein zweites Gitter (G32) zwischen dem zweiten und dem dritten Pixel vorgesehen ist und ein drittes Gitter (G43) zwischen dem dritten und dem vierten Pixel vorgesehen ist und Mittel zum Steuern der Gitter in zwei aufeinander folgenden Schritten vorgesehen sind, wobei das Speichersteuersignal des ersten Gitters zur selben Zeit an dieses angelegt wird wie das Speichersteuersignal des zweiten Gitters und das Speichersteuersignal des dritten Gitters erst nach dem Ende des an das erste und zweite Gitter angelegten Speichersteuersignals an dieses angelegt wird.

6. Bildsensor nach Anspruch 1 oder 2, **dadurch gekennzeichnet, dass** die Matrix in Gruppen von nxm Pixeln organisiert sind, wobei (n+m)>=2 ist, und (nxm-1) temporäre Speichergitter zwischen Fotodioden von benachbarten Pixeln umfasst, um die Gruppierung von Ladungen einer Gruppe von nxm Pixeln zu gewährleisten.

7. Bildsensor nach Anspruch 6, **dadurch gekennzeichnet, dass** Mittel zum Erzeugen von n+m-2 Steuersignalen zum Steuern der temporären Speichergitter der Matrix vorgesehen sind.

## Claims

1. An image sensor comprising a matrix of pixel rows and columns, each pixel having a photodiode and a node for storing charges in order to collect, at the end of a charge integration period, the charges accumulated in the photodiode, the photodiodes being produced in an active semiconductor layer of a first type of conductivity and comprising a diffusion of a second type of conductivity covered by a surface layer of the first type connected to a reference potential of the active layer and the matrix being organized in groups of at least two adjacent pixels, with means for grouping in one pixel the charges generated in the two pixels, comprising at least one charge storage gate (G21) arranged between the photodiode (PD1) of the first pixel and the photodiode (PD2) of the second pixel, the temporary storage gate being disposed above an active layer portion of the first type and dissymmetrically set up between an upstream and a downstream side, being:
- on the upstream side, adjacent to the photodiode (PD1) of the first pixel by the end of at least one narrow finger (DGT) extending towards this photodiode (PD1),
- on the downstream side, adjacent to the photodiode (PD2) of the second pixel by a dimension wider than the narrow finger,
- and, with the exception of the end of the narrow finger, separated from the photodiode of the first pixel by a doped insulation region of the first type of conductivity, which is more doped than the surface regions of the photodiodes, and is brought, as item, to the potential of the active layer
and means being provided for applying to the temporary storage gate a succession of potentials that are:
- a low potential prohibiting the passage of charges between the photodiode (PD1) of the first pixel and the photodiode (PD2) of the second pixel during the charge integration period,
- then a high potential temporary storage control signal permitting the discharge of the charges accumulated in the photodiode (PD1) of the first pixel and the photodiode (PD2) of the second pixel under the temporary storage gate,
then a low potential allowing the discharge of the charges on the intermediate storage gate toward the photodiode (PD2) of the second pixel only.

2. An image sensor according to claim 1, **characterized in that** the active layer portion located under the gate comprises a plurality of narrow fingers extending towards the photodiode of the first pixel and having an end adjacent to this photodiode.

3. An image sensor according to claim 1 or 2, **characterized in that** the matrix is organized into groups of four adjacent two-to-two pixels on a line or column, a first (PD1) and a second (PD2) pixel of a group of four are two adjacent pixels of a first row of pixels and a third (PD3) and a fourth (PD4) pixels are two adjacent pixels of another line adjacent to the first, and at least three dissymmetric temporary storage gates (G21, G32, G43) being provided in order to permit grouping of charges on the photodiodes of the four pixels into the photodiode of the fourth pixel, each gate being of dissymmetric form, arranged between two adjacent pixels of the group of four in order to allow directional transfer of the charges from the photodiode from one pixel to the photodiode of the other pixel.

4. An image sensor according to claim 3, **characterized in that** a first temporary storage gate (G21) is provided between the first and the second pixel, a second gate (G32) is provided between the second and the third pixel, and a third gate (G43) is provided between the third and fourth pixels, and means are provided for controlling the gates successively, the storage control signal of the second gate (ST32) being applied thereto only after the end of the storage control signal (ST21) applied to the first gate and the storage control signal of the third gate (ST43) being applied thereto only after the end of the storage control signal (ST32) applied at the second gate.

5. An image sensor according to claim 3, **characterized in that** a first temporary storage gate (G41) is provided between the first and the fourth pixel, a second gate (G32) is provided between the second and the third pixel, and a third gate (G43) is provided between the third and fourth pixels, and means are provided for controlling the gates in two successive stages, the storage control signal for the first gate being applied to the latter at the same time as the storage control signal for the second gate, and the storage control signal for the third gate being applied to the latter only after the end of the storage control signal applied to the first and second gates.

6. An image sensor according to claim 1 or 2, **characterized in that** the matrix is organized in groups of nxm pixels, with (n + m)> = 2 and comprises (nxm-1) temporary storage gates between photodiodes of adjacent pixels for grouping of charges form a group of nxm pixels.

7. An image sensor according to claim 6, **characterized in that** means are provided for setting up n + m-2 control signals for controlling the temporary storage gates of the array.
